# EUROPÄISCHE PATENTSCHRIFT

(11) **EP 1 192 476 B1**
(45) Veröffentlichungstag und Bekanntmachung des Hinweises auf die Patenterteilung: **30.07.2008**
(21) Anmeldenummer: 00945713.6
(22) Anmeldetag: 07.06.2000
(51) Int. Cl.: G01R 33/28

(54) **PROBENZELLE FÜR EINEN POLARISATOR VON EDELGASEN**
TEST CELL FOR A NOBLE GAS POLARIZER
CELLULE D'ESSAI POUR POLARISEUR DE GAZ RARES

(30) Priorität: 18.06.1999 DE 19927788
(43) Veröffentlichungstag der Anmeldung: 03.04.2002
(73) Patentinhaber: Forschungszentrum Jülich GmbH, 52425 Jülich (DE)
(72) Erfinder: APPELT, Stephan, 52428 Jülich (DE); D'ORSANEO, Giovanni, 52428 Jülich-Broich (DE); SHAH, Nadim, Joni, 52441 Linnich-Boslar (DE)
(74) Vertreter: Gille Hrabal Struck Neidlein Prop Roos
(86) Internationale Anmeldenummer: PCT/EP2000/005251
(87) Internationale Veröffentlichungsnummer: WO 2000/079244

(56) Entgegenhaltungen:
- US-A- 5 642 625
- ROSEN M S ET AL: "Polarized Xe optical pumping/spin exchange and delivery system for magnetic resonance spectroscopy and imaging studies" REVIEW OF SCIENTIFIC INSTRUMENTS,AMERICAN INSTITUTE OF PHYSICS. NEW YORK,US, Bd. 70, Nr. 2, Februar 1999 (1999-02), Seiten 1546-1552, XP000942379 ISSN: 0034-6748
- DRIEHUYS B ET AL: "HIGH-VOLUME PRODUCTION OF LASER-POLARIZED 129XE" APPLIED PHYSICS LETTERS,US,AMERICAN INSTITUTE OF PHYSICS. NEW YORK, Bd. 69, Nr. 12, 16. September 1996 (1996-09-16), Seiten 1668-1670, XP000629162 ISSN: 0003-6951 in der Anmeldung erwähnt

## Beschreibung

Die Erfindung betrifft eine Probenzelle für einen Polarisator von Edelgasen. Die Erfindung betrifft ferner ein Verfahren zur Herstellung der Probenzelle.

Es ist eine Probenzelle für einen Polarisator von Edelgasen bekannt, die aus Glas besteht, einen Einlaß und einen Auslaß für Gas aufweist und durch die das Licht eines Lasers hindurch geleitet wird.

Neuere Entwicklungen in der Magnet Resonanz Tomographie (MRT) sowie in der Magnet Resonanz Spektroskopie (NMR) mit polarisierten Edelgasen lassen Anwendungen in der Medizin, in der Physik und in den Materialwissenschaften erwarten. Große Polarisationen von Kernspins können durch optisches Pumpen mit Hilfe von Alkaliatomen erzielt werden, wie der Druckschrift Happer et al., Phys. Rev. A, 29, 3092 (1984) zu entnehmen ist. Typischerweise wird zur Zeit Rubidium in Anwesenheit eines Edelgases und Stickstoff eingesetzt. Auf diese Weise ist es möglich, eine Kernspinpolarisation des Edelgases Xenon (¹²⁹Xe) von ca. 20 Prozent zu erreichen. Eine solche Kernspinpolarisation ist ca. 100 000 mal größer als die Gleichgewichtspolarisation in klinischen Magnet Resonanz Tomographen. Die damit verbundene drastische Steigerung des Signal - Rausch - Verhältnisses erklärt, weshalb in Zukunft neue Anwendungsmöglichkeiten in der Medizin, Wissenschaft und Technik erwartet werden.

Unter Polarisation wird der Grad der Ausrichtung (Ordnung) der Spins von Atomkernen oder Elektronen verstanden. 100 Prozent Polarisation bedeutet zum Beispiel, daß sämtliche Kerne oder Elektronen in gleicher Weise orientiert sind. Mit der Polarisation von Kernen oder Elektronen ist ein magnetisches Moment verbunden.

Polarisiertes Xenon wird zum Beispiel von einem Menschen inhaliert oder in ihn injiziert. 10 bis 15 Sekunden später sammelt sich das polarisierte Xenon im Gehirn an. Mit Hilfe der Magnetischen Resonanz Tomographie wird die Verteilung des Edelgases im Gehirn festgestellt. Das Ergebnis wird für weitere Analysen genutzt.

Die Wahl des Edelgases hängt vom Anwendungsfall ab. ¹²⁹Xenon weist eine große chemische Verschiebung auf. Wird Xenon z. B. auf einer Oberfläche adsorbiert, so verändert sich signifikant seine Resonanzfrequenz. Außerdem löst sich Xenon in fettliebenden (d. h.: lipophilen) Flüssigkeiten. Wenn derartige Eigenschaften erwünscht sind, wird Xenon eingesetzt.

Das Edelgas Helium löst sich kaum in Flüssigkeiten. Das Isotop ³Helium wird daher regelmäßig dann verwendet, wenn Hohlräume betroffen sind. Die Lunge eines Menschen stellt ein Beispiel für einen solchen Hohlraum dar.

Einige Edelgase weisen andere wertvolle Eigenschaften als die vorgenannten auf. So besitzen z. B. die Isotope ⁸³Krypton, ²¹Neon und ¹³¹Xenon ein Quadrupolmoment, welches z. B. für Experimente in der Grundlagenforschung bzw. in der Oberflächenphysik interessant sind. Diese Edelgase sind allerdings sehr teuer, so daß diese für Anwendungen, bei denen größere Mengen verwendet werden, ungeeignet sind.

Aus der Druckschrift "B. Driehuys et al., Appl. Phys. Lett. 69, 1668 (1996) ist bekannt, Edelgase auf folgende Weise zu polarisieren.

Mit Hilfe eines Lasers wird zirkular polarisiertes Licht bereitgestellt, also Licht, bei dem der Drehimpuls bzw. der Spin der Photonen alle in die gleiche Richtung zeigen. Der Drehimpuls der Photonen wird auf freie Elektronen von Alkaliatomen übertragen. Die Spins der Elektronen der Alkaliatome weisen somit eine große Abweichung vom thermischen Gleichgewicht auf. Die Alkaliatome sind somit polarisiert. Durch einen Stoß von einem Alkaliatom mit einem Atom eines Edelgases wird die Polarisation des Elektronenspins vom Alkaliatom auf das Atom des Edelgases übertragen. Es entsteht so polarisiertes Edelgas.

Alkaliatome werden eingesetzt, da diese über ein großes optisches Dipolmoment verfügen, welches mit dem Licht wechselwirkt. Ferner weisen Alkaliatome jeweils ein freies Elektron auf, so daß keine nachteilhaften Wechselwirkungen zwischen zwei und mehr Elektronen pro Atom auftreten können.

Cäsium wäre ein besonders gut geeignetes Alkaliatom, welches gegenüber Rubidium zur Erzielung vorgenannter Wirkungen überlegen ist. Es stehen jedoch zur Zeit keine Laser mit genügend hoher Leistung zur Verfügung, wie sie für die Polarisation von Xenon mittels Cäsium benötigt würden. Es ist jedoch zu erwarten, daß in Zukunft Laser mit Leistungen um 100 Watt auf der Cäsiumwellenlänge entwickelt werden. Dann wird voraussichtlich bevorzugt Cäsium für die Polarisation von Edelgasen eingesetzt.

Der Stand der Technik ist, ein Gasgemisch unter einem Druck von typischerweise 7 bis 10 bar (1 bar entspricht 10⁵ Pascal) durch eine zylindrische Glaszelle langsam durchzuleiten. Das Gasgemisch besteht zu 98 Prozent aus ⁴Helium, einem Prozent Stickstoff bzw. einem Prozent Xenon. Die typischen Geschwindigkeiten des Gasgemisches betragen einige ccm pro Sekunde.

Das Gasgemisch durchströmt zunächst ein Gefäß (nachfolgend "Vorratsgefäß" genannt), in dem sich ca. ein Gramm Rubidium befindet. Das Vorratsgefäß mit dem darin befindlichen Rubidium wird zusammen mit der sich anschließenden Glaszelle auf ca. 100 bis 150 Grad Celsius erwärmt. Durch Bereitstellung dieser Temperaturen wird das Rubidium verdampft. Die Konzentration der verdampften Rubidium-Atome in der Gasphase wird durch die Temperatur im Vorratsgefäß bestimmt. Der Gasstrom transportiert die verdampften Rubidium - Atome von dem Vorratsgefäß in die zylindrische Probenzelle. Ein leistungsstarker, zirkular polarisierter Laser (100 Watt Leistung im kontinuierlichen Betrieb) durchstrahlt die Probenzelle (auch nachfolgend " Glaszelle " genannt) axial und pumpt optisch die Rubidium - Atome in einen hochpolarisierten Zustand. Die Wellenlänge des Lasers muß dabei auf die optische Absorptionslinie der Rubidium - Atome (D 1 - Linie) abgestimmt sein. Mit anderen Worten: Um die Polarisation vom Licht auf ein Alkaliatom optimal zu übertragen, muß die Frequenz des Lichts mit der Resonanzfrequenz des optischen Übergangs übereinstimmen. Die Probenzelle befindet sich in einem statischen magnetischen Feld von einigen 10 Gauss, das von einer Spule (Helmholtzspulenpaar) erzeugt wird. Die Richtung des magnetischen Feldes verläuft parallel zur Zylinderachse der Probenzelle bzw. parallel zur Strahlrichtung des Lasers. Das Magnetfeld dient der Führung der polarisierten Alkaliatome. Die durch das Licht des Lasers optisch hochpolarisierten Rubidium - Atome kollidieren in der Glaszelle u. a. mit den Xenon - Atomen und geben ihre hohe Polarisation an die Xenon - Atome ab. Am Ausgang der Probenzelle scheidet sich das Rubidium aufgrund des hohen Schmelzpunkts im Vergleich zu den Schmelzpunkten der übrigen Gasen an der Wand ab. Das polarisierte Xenon bzw. das Gasgemisch wird von der Probenzelle in eine Ausfriereinheit weitergeleitet. Diese besteht aus einem Glaskolben, dessen Ende in flüssigem Stickstoff getaucht ist. Der Glaskolben befindet sich ferner in einem Magnetfeld mit einer Stärke von 1000 bis 2000 Gauss. Das hochpolarisierte Xenon-Gas scheidet sich an der inneren Glaswand der Ausfriereinheit als Eis ab, soweit die Glaswand in die aus Stickstoff bestehende Flüssigkeit getaucht ist. Am Auslaß der Ausfriereinheit wird das restliche Gas (Helium und Stickstoff) über ein Nadelventil geleitet und schließlich abgelassen.

Die Flußgeschwindigkeit in der gesamten Anordnung kann über das Nadelventil gesteuert und mit einem Meßgerät gemessen werden. Steigt die Flußgeschwindigkeit zu sehr an, so verbleibt keine Zeit zur Übertragung der Polarisation von den Rubidium - Atomen auf die Xenon - Atome. Es wird also keine Polarisation erzielt. Ist die Flußgeschwindigkeit zu niedrig, so verstreicht zuviel Zeit, bis die gewünschte Menge an hochpolarisiertem Xenon eingefroren ist. Durch Relaxation nimmt die Polarisation der Xenon - Atome nämlich wieder ab. Die Relaxation der Xenon-Atome wird durch das Einfrieren sowie durch das starke Magnetfeld, welchem die Ausfriereinheit ausgesetzt ist, stark verlangsamt. Es ist daher erforderlich, nach der Polarisierung das Edelgas möglichst schnell und verlustfrei einzufrieren. Zwar kann die Relaxation durch das Einfrieren nicht vermieden werden. Es verbleiben bei T=77 K jedoch noch 1 bis 2 Stunden Zeit, ehe die Polarisation so stark abgenommen hat, daß eine weitere Verwendung des anfangs hochpolarisierten Gases nicht mehr möglich ist.

Um ein einzelnes, freies Alkaliatom zu polarisieren, ist eine bestimmte Energie erforderlich. Diese erforderliche Energie entspricht der Resonanzfrequenz zur Anhebung des freien Elektrons des Alkaliatoms von dem Grundzustand in einen angeregten Zustand. Um die Energie von einem Laser auf das Alkaliatom optimal zu übertragen, muß die Frequenz des Lichts des Lasers auf die Resonanzfrequenz des Alkaliatoms abgestimmt werden. Allgemein senden Laser ihr Licht innerhalb eines bestimmten Frequenzspektrums aus. Es handelt sich dabei also nicht um eine einzelne Frequenz, sondern um eine Verteilung von Frequenzen. Das zur Verfügung stehende Spektrum eines Lasers wird durch die sogenannte Linienbreite charakterisiert. Am effektivsten werden Alkaliatome polarisiert, wenn die Linienbreite des Lasers übereinstimmt mit der Linienbreite des optischen Übergangs des Alkaliatoms. Die optische Linienbreite eines Alkaliatoms ist nun proportional zum Druck des beigemischten ⁴Helium Lasers (Druckverbreiterung) . Je höher nämlich der Druck ist, umso höher ist die Anzahl der Stöße zwischen einem Alkaliatom und einem Stoßpartner wie Helium.

Bei dem gemäß Stand der Technik eingesetzten 100 Watt starken Laser handelt es sich um einen glasfasergekoppelten Diodenlaser mit einer typischen Spektralbreite von 2 Nanometern. Bei einem Gasdruck von 10 bar ist die Linienbreite des optischen Überganges von Rubidiumatomen auf ca. 0,3 Nanometer verbreitert. Daher wird in den vorhandenen Rubidium - Xenon - Polarisatoren, in denen zum optischen Pumpen teure Diodenlaser mit typischerweise 2 Nanometer Linienbreite eingesetzt werden, nur ein Bruchteil des Laserlichts genutzt. Verwendet man bei 10 bar Gasdruck die erheblich billigeren Diodenlaser mit 4 - 5 nm Linienbreite, ist die Effizienz noch wesentlich geringer.

Die Partialdrucke von Helium betragen in einem Gasgemisch gemäß Stand der Technik zur Zeit bis zu 10 bar. Im Vergleich zu den übrigen Partialdrucken ist dieser sehr hoch. Außer der Druckverbreiterung des optischen Übergangs des Alkaliatoms bewirkt der hohe Partialdruck, daß polarisierte Atome nur selten an die Probenwand der Glaszelle gelangen und dort z.B. durch Wechselwirkung mit paramagnetischen Zentren ihre Polarisation verlieren. Mit zunehmenden Partialdruck des Heliums nimmt die Wahrscheinlichkeit ab, daß polarisierte Atome nachteilhaft an die Zellenwand stoßen.

Um die volle Leistung des Lasers zu nutzen und gleichzeitig nachteilhafte Relaxationseffekte durch Stöße mit der Wand zu reduzieren, müßte bei Helium - Drucken weit oberhalb von 30 bar gearbeitet werden.

Bei der Zusammenstellung des Gasgemisches ist ferner folgendes zu beachten.

Ein Alkaliatom, wie z.B. Rubidium, vermag nach Absorption eines vom Laser stammenden Photons ein Photon aufgrund von Fluoreszenz (Fluoreszenzphoton) zu emittieren. Wird ein solches Fluoreszenzphoton von einem benachbarten polarisierten Alkaliatom eingefangen, so führt dieser Einfang zur Depolarisation des Alkaliatoms. Der bei der Polarisation von Edelgasen eingesetzte Stickstoff im Gasgemisch dient der Unterdrückung ("Quenchen") dieser Fluoreszenzstrahlung, um damit die vorgenannte unerwünschte Depolarisation herabzusetzen. Der Stickstoff-Partialdruck beträgt typischerweise beim Stand der Technik um die 0,1 bar.

Die schweren Edelgas - Atome, also z.B. Xenon - Atome verursachen bei Stößen mit den Alkaliatomen eine starke Relaxation der Polarisation der Alkaliatome. Um die Polarisation der Alkaliatome beim optischen Pumpen so groß wie möglich zu halten, muß der Partialdruck der Edelgase im Gasgemisch entsprechend klein sein. Selbst bei einem Xenon - Partialdruck im Gasgemisch von nur 0,1 bar braucht man Laserleistungen um die 100 Watt, um im ganzen Probenvolumen Polarisationen der Alkaliatome von 70 Prozent zu erreichen.

Beim Stand der Technik werden Glaszellen eingesetzt, die aus einem Stück Glas geblasen sind. Es war bisher nicht möglich, auf andere Weise eine Glaszelle zu schaffen, die die gewünschten hohen Drucke auszuhalten vermochte und gleichzeitig eine hohe optische Qualität gewährleistet. Die vorgenannte Herstellung der Glaszelle hat zur Folge, daß die Fenster, durch die das Licht des Lasers ein- und austritt, stets gekrümmt bzw. abgerundet sind. Es treten beim Eintritt oder Austritt des Lichts des Lasers unerwünschte, nachteilhafte Linseneffekte auf. Das Licht des Lasers wird fokussiert oder aufgeweitet. Hierdurch verschlechtert sich die Effizienz, Alkaliatome im Gasgemisch der Glaszelle zu polarisieren, erheblich.

Eine Glaszelle für die Polarisation von Edelgasen soll folgende Anforderungen erfüllen.

Sie muß einen hohen Druck von wenigstens 10 bar aushalten, unmagnetisch bzw. resistent gegenüber Alkalimetalen bei Temperaturen von bis zu 200 Grad Celsius sein.

Die Glaszelle soll mit Ventilen verschlossen werden können. Die Ventilköpfe bzw. Dichtungsringe müssen 200 Grad Celsius in Anwesenheit von dem Gasgemisch überstehen, außerdem unmagnetisch und druckfest sein. Der Einfluß der Ventile auf die Polarisation des Edelgases sollte so gering wie möglich sein.

Die Oberfläche im Inneren der Zelle soll keinen zerstörenden Einfluß auf die Xenon - bzw. auf die Rubidium - Polarisation haben. Es sollten sich daher keine paramagnetischen oder gar ferromagnetischen Zentren an der Innenwand der Zelle befinden. Auch sollte das Material, aus dem die Zelle besteht, absolut unmagnetisch sein.

Das Licht des Lasers soll sich möglichst ohne Linseneffekte, d. h. parallel durch die Zelle ausbreiten können.

Das Eintrittsfenster der Zelle soll so wenig wie möglich das Licht des Lasers absorbieren. Anderenfalls wird insbesondere das Eintrittsfenster zu stark erhitzt und schließlich zerstört.

Das Eintrittsfenster soll weder bei Normaldruck noch bei hohem Druck doppelbrechend sein. Anderenfalls würde die Zirkularpolarisation des Lasers zerstört oder zumindest gemindert.

Aufgabe der Erfindung ist die Schaffung einer Probenzelle, bei der gegenüber dem Stand der Technik insbesondere ein verbesserter Strahlengang möglich ist.

Die Aufgabe der Erfindung wird durch eine Probenzelle gelöst, die die Merkmale des ersten Anspruchs aufweist. Ein Verfahren zur Herstellung der Probenzelle weist die Merkmale des Anspruchs 10 auf. Vorteilhafte Ausgestaltungen ergeben sich aus den Unteransprüchen.

Iie anspruchsgemäße Glaszelle weist einen Glaskörper mit einer Öffnung auf. In die Öffnung ist ein planes Fenster aus Glas hineingeschoben. Die Form und Größe des Fensters entspricht der Form und Größe der Öffnung. Die Öffnung weist einen Rand auf, der breiter ist als die Dicke des Fensters. Hierdurch soll bewirkt werden, daß zwischen dem Fenster und dem Rand der Öffnung ein großflächiger Kontakt möglich ist. Der Rand des Fensters ist mit dem Rand der Öffnung verschmolzen.

Es kann so eine Glaszelle zur Verfügung gestellt werden, die ein Eintrittsfenster aufweist, welches flach ist. Hierdurch wird ein paralleler Strahlengang durch das Fenster sichergestellt.

Der Glaskörper umfaßt ferner einen Einlaß und einen Auslaß für Gas.

Der Glaskörper weist insbesondere die Form eines Zylinders auf. Das plane Fenster ist dann durch eine Scheibe gebildet. Der Durchmesser der Scheibe entspricht dem Innendurchmesser des Glaskörpers. Die Scheibe wird ein Stück in den Zylinder hineingeschoben. Die Innenwand des Zylinders stellt dann eine große Kontaktfläche bereit, die mit dem Rand der Scheibe verschmolzen werden kann. Diese Innenfläche bildet dann den Rand der Öffnung, der breiter ist als die Dicke des Fensters.

Vorteilhaft werden beide Öffnungen des Zylinders mit je einem planen Fenster verschlossen.

Der Zylinder weist ferner einen Ein- und einen Auslaß für das Gas auf.

Um das Fenster fest mit der Glaszelle zu verbinden, wird der Rand mehrfach insbesondere auf 1400 bis 1500 °C so erhitzt, daß der betroffene Bereich mehrfach aufgeschmolzen wird. Handelt es sich bei dem Glaskörper um einen Zylinder, so wird dieser von außen erhitzt, um ein eingeschobenes Fenster mit dem Zylinder zu verschmelzen.

Durch das wiederholte Aufschmelzen entsteht an der Innen- und Außenkante des Fensters ein Radius von 1 - 2 mm. Hierdurch wird erreicht, daß die Glaszelle druckfest ist und gleichzeitig wenigstens ein planes Eintrittsfenster aufweist.

Vorteilhaft wird ein Fenster vor dem Einbauen bzw. vor dem Verschmelzen mit dem Rand der Öffnung des Glaskörpers geschliffen und anschließend mit einer Säure, insbesondere mit 15 prozentiger Flußsäure gereinigt. Insbesondere wird der Rand rund geschliffen. Durch diese Schritte wird eine ganz besonders haltbare Verbindung mit dem Rand der Öffnung des Glaskörpers gewährleistet.

Als Material für den Glaskörper wird Borosilikatglas und für das oder die Fenster Borofloatglas (Borosilikatglas 3.3 ISO-Norm) vorgesehen. Beide Materialien haben denselben thermischen Ausdehnungskoeffizienten und lassen sich deshalb besonders gut verschmelzen. Außerdem besitzen beide Borosilikatglase wenig paramagnetische Zentren und werden praktisch nicht, wie z.B. Quarzglas, unter Druckbelastung doppelbrechend.

Typischerweise weist der Glaskörper, also z.B. der Zylinder einen Innendurchmesser von 24 Millimetern auf. Die Wandstärke liegt bei oder oberhalb von 5 Millimetern. Ein Radius, der das Fenster mit dem Glaskörper verbindet, steht typischerweise 1 bis 2 Millimeter vor.

Eine solche Glaszelle hält einem Druck von 15 bar stand.

Am Eingang bzw. am Ausgang der Probenzelle sind vorteilhaft Ventile vorgesehen, die überwiegend aus Glas gefertigt sind. Soweit Dichtringe bei den Glasventilen eingesetzt wurden, bestanden diese aus Ethylenpropylen. Ethylenpropylen ist alkaliresistent und weist keine paramagnetischen Zentren auf. Ferner nimmt das Material praktisch kein Edelgas auf.

Nach einer Messung einer Xenonpolarisation mit Hilfe von NMR unmittelbar vor und nach einem solchen Ventil zeigte sich kein nennenswerter Polarisationsverlust.

Anhand der nachfolgenden Figuren wird die Erfindung näher erläutert.

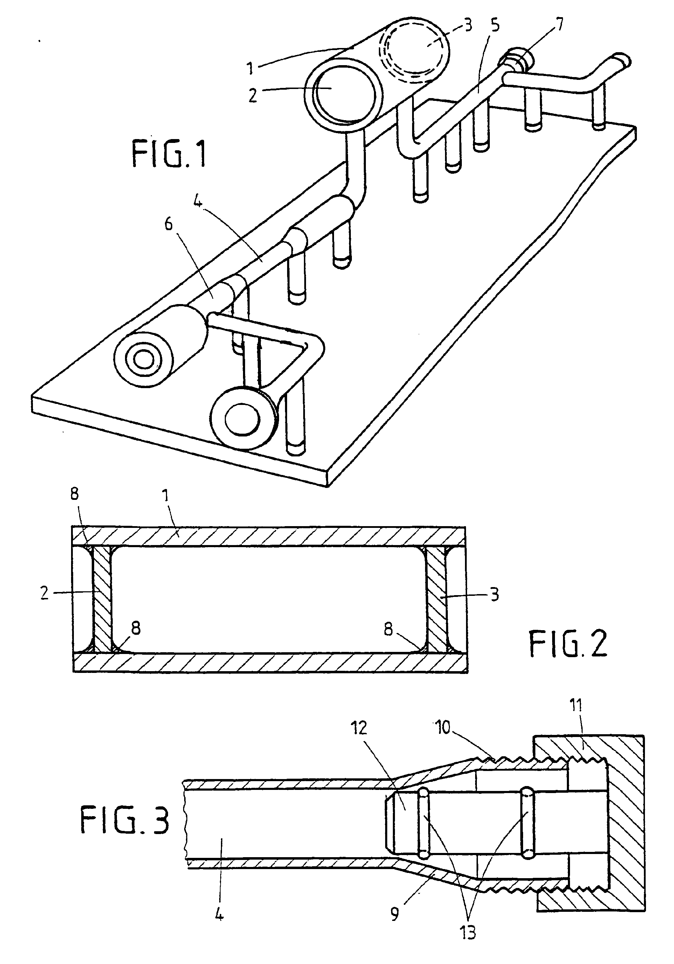

Figur 1 zeigt den grundsätzlichen Aufbau der Probenzelle. Die Probenzelle setzt sich aus einem aus Glas bestehenden Zylinder 1 und zwei planen Fenstern 2 und 3 zusammen. Die planen Fenster 2 und 3 sind ein Stück in die jeweiligen Enden des Zylinders hineingeschoben. Die Fenster 2 und 3 sind mit dem Zylinder 1 fest verbunden. Über Rohre 4 und 5 wird das Gasgemisch zunächst in die Probenzelle hineingeleitet und nach der Polarisierung wieder herausgeleitet. Die Rohre 4 und 5 können durch Ventile 6 und 7 verschlossen werden. Einlaßrohr 4 weist einen Abschnitt mit vergrößertem Durchmesser zwischen dem Ventil 6 und der Probenzelle 1, 2, 3 auf. Dieser Abschnitt dient zur Aufnahme von Alkalimetall, welches hier verdampft und dann in die Probenzelle transportiert werden kann.

Figur 2 zeigt die Probenzelle im Querschnitt. In den Zylinders 1 sind Eintrittsfenster 2 und Austrittsfenster 3 ein Stück hineingeschoben. Durch mehrfaches Aufschmelzen sind die Fenster 2 und 3 mit dem Zylinder 1 verbunden worden. Durch das mehrfache Aufschmelzen haben sich Radien 8 gebildet. Die Radien 8 bilden eine Schmelzverbindung zwischen den planen Fenstern 2 und 3 und dem Zylinder 1. Die Radien 8 befinden sich zu beiden Seiten eines jeweiligen Fensters 2 und 3 und grenzen an den Zylinder 1. Der Zylinder 1 besteht aus Borosilikatglas. Die Fenster bestehen aus Borofloatglas. Die Wandstärke des Zylinders beträgt 5 mm. Die Fenster weisen ebenfalls eine Wandstärke von fünf Millimetern auf. Der Außendurchmesser des Zylinders beträgt ca. 35 bis 40 mm.

Borofloatglas und Borosilikatglas weisen den gleichen thermischen Ausdehnungskoeffizienten auf. Daher verschmelzen die Fenster mit dem Zylinder besonders gut. Es liegt anschließend eine sehr druckfeste Zelle vor, die selbst Drucke von 15 bar verkraftet.

Figur 3 zeigt einen Querschnitt durch ein Ventil 6 oder 7. Das Ende einer aus Glas bestehenden Leitung 4 (Rohr) mündet in einen Trichter 9 ein. An den Trichter schließt sich ein Gewinde 10 an. Auf das Gewinde 10 ist eine aus Kunststoff bestehende Kappe 11 aufgeschraubt. Die Kappe 11 verfügt über ein entsprechendes Innengewinde. Ein aus Glas bestehender Bolzen 12 ist an der Kappe 11 zentral innen befestigt. Der Bolzen 12 reicht in den Trichter 9 hinein. Der Bolzen 12 weist zwei Rillen auf, in denen sich 0 - Ringe 13 befinden. Die 0 - Ringe 13 bestehen aus Ethylenpropylen. Nicht da-gestellt ist ein abzweigendes Rohr, welches sich am oberen Rand mit dem großen Durchmesser des Trichters 9 befindet. Es kann ferner ein nicht eingezeichnetem Zwischenrohrstück zwischen Trichter 9 und Gewinde 10 vorgesehen sein, von dem aus ein Rohr abzweigt.

Wird die Kappe 11 hineingeschraubt, so schließt der vordere O - Ring dicht mit dem Trichter 9 ab. Das Ventil ist dann geschlossen.

Der Bolzen 12 kann einen größeren Außendurchmesser als der Innendurchmesser des Rohres 4 aufweisen und an dem Ende, welches dem Trichter zugewandt ist, einen sich verjüngenden, in den Trichter einmündenden Abschnitt aufweisen. Dieser Abschnitt dient als Gegenstück zum Trichter. Ein O-Ring ist so beim verjüngenden Abschnitt angebracht, daß dieser mit dem Trichter 9 dicht abschließt, wenn der Bolzen 12 entsprechend weit in Richtung Trichter durch Schrauben der Kappe 11 bewegt worden ist. Insbesondere bei dieser Ausführungsform sind die genannten hohe Drücke möglich.

## Patentansprüche

1. Probenzelle für einen Polarisator von Edelgasen mit einem Glaskörper (1), der einen Einlass (4) und einen Auslass (5) für Gas aufweist,
**gekennzeichnet durch** folgende Merkmale:
- der Glaskörper weist wenigstens eine weitere Öffnung auf,
- in die weitere Öffnung ist ein planes Fenster (2) aus Glas hineingeschoben,
- die Form und Grösse des Fensters (2) entspricht der Form und Grösse der weiteren Öffnung,
- die weitere Öffnung wird **durch** eine den Rand der Öffnung bildende Innenfläche des Glaskörpers begrenzt,
- die Innenfläche ist der Ausdehnung nach breiter als das Fenster dick ist,
- der Rand des Fensters ist mit dem Rand der Öffnung verschmolzen.

2. Probenzelle nach Anspruch 1, **dadurch gekennzeichnet, daß** der Glaskörper die Form eines Zylinders (1) aufweist, wobei das plane Fenster (2) durch eine Scheibe gebildet ist, die an einem Ende des Zylinders in den Glaskörper hineingeschoben ist.

3. Probenzelle nach Anspruch 1 oder 2, **dadurch gekennzeichnet, daß** die Probenzelle zwei plane Fenster (2, 3) aufweist, die zueinander parallel angeordnet sind.

4. Probenzelle nach einem der vorhergehenden Ansprüche, **gekennzeichnet durch** zwei vorstehende Radien (8) von wenigstens einem Millimeter zu beiden Seiten des oder der Fenster, die unmittelbar benachbart zum Umfang des Fensters angeordnet sind und die eine druckfeste Verbindung zum Rand der Öffnung bilden.

5. Probenzelle nach einem der vorhergehenden Ansprüche, **gekennzeichnet durch** Borosilikatglas, aus dem der Glaskörper (1) und Borofloatglas, aus dem die Fenster (2, 3) bestehen.

6. Probenzelle nach einem der vorhergehenden Ansprüche, **dadurch gekennzeichnet, daß** das Glas (1, 2, 3) wenigstens 5 mm dick ist.

7. Probenzelle nach einem der vorhergehenden Ansprüche, **dadurch gekennzeichnet, daß** der Außendurchmesser des Glaskörpers (1) zwischen 20 und 100 Millimetern, insbesondere zwischen 35 und 40 Millimetern liegt.

8. Probenzelle nach einem der vorhergehenden Ansprüche, **dadurch gekennzeichnet, daß** die Probenzelle Teil eines Polarisators für die Polarisation eines Edelgases ist.

9. Probenzelle nach einem der vorhergehenden Ansprüche, **dadurch gekennzeichnet, daß** am Eingang bzw. am Ausgang für das Gas aus Glas gefertigte Ventile (6, 7) vorgesehen sind, die Dichtringe aus Ethylenpropylen umfassen.

10. Verfahren zur Herstellung einer Probenzelle für einen Polarisator von Edelgasen nach einem der vorhergehenden Ansprüche, wobei
- ein Glaskörper mit einem Einlass und einem Auslass für Gas sowie mit einer weiteren Öffnung bereitgestellt wird,
- in die weitere Öffnung ein planes Fenster hineingeschoben wird, dessen Umfang dem Umfang der weiteren Öffnung entspricht und dessen Dicke geringer ist als die Breite der Innenfläche des Glaskörpers, welche den Rand der weiteren Öffnung bildet und diese begrenzt, und
- der Rand der weiteren Öffnung von aussen wenigstens zweifach so erhitzt wird, dass das Glas in der Nähe des Rands schmilzt, so dass eine Schmelzverbindung zwischen dem Fenster und dem Rand entsteht.

11. Verfahren nach Anspruch 10, bei dem der oder die Ränder eines jeden Fensters vor dem Hineinschieben sowie vor dem Verschmelzen mit dem Rand der Öffnung des Glaskörpers geschliffen, insbesondere der Rand rund geschliffen wird und anschließend mit einer Säure, insbesondere mit Flußsäure gereinigt wird.

12. Verwendung einer Probenzelle für einen Polarisator von Edelgasen nach einem der Vorrichtungsansprüche 1-9 bei Drucken von wenigstens 1 MPa (10 bar) innerhalb der Probenzelle.

## Claims

1. Test cell for a noble gas polariser with a glass body (1) which has an inlet (4) and an outlet (5) for gas, **characterised by** the following features:
- the glass body has at least one further opening,
- a plane window (2) of glass is inserted in the further opening,
- the shape and size of the window (2) correspond to the shape and size of the further opening,
- the further opening is defined by an inner surface of the glass body which forms the edge of the opening,
- in terms of extent the inner surface is wider than the window is thick,
- the edge of the window is fused to the edge of the opening.

2. Test cell according to Claim 1, **characterised in that** the glass body has the shape of a cylinder (1), wherein the plane window (2) is formed by a disc which is inserted in the glass body at one end of the cylinder.

3. Test cell according to Claim 1 or 2, **characterised in that** the test cell has two plane windows (2, 3) which are disposed parallel to one another.

4. Test cell according to any one of the preceding Claims, **characterised by** two projecting radii (8) of at least one millimetre on both sides of the window or windows, which radii are disposed directly adjacent to the circumference of the window and form a pressure-proof connection with the edge of the opening.

5. Test cell according to any one of the preceding Claims, **characterised by** borosilicate glass, of which the glass body (1) consists, and Borofloat glass, of which the windows (2, 3) consist.

6. Test cell according to any one of the preceding Claims, **characterised in that** the glass (1, 2, 3) is at least 5 mm thick.

7. Test cell according to any one of the preceding Claims, **characterised in that** the outside diameter of the glass body (1) is between 20 and 100 millimetres, in particular between 35 and 40 millimetres.

8. Test cell according to any one of the preceding Claims, **characterised in that** the test cell is part of a polariser for the polarisation of a noble gas.

9. Test cell according to any one of the preceding Claims, **characterised in that** valves (6, 7) made of glass are provided at the entrance and at the exit for the gas, which valves comprise sealing rings of ethylene propylene.

10. Method for producing a test cell for a noble gas polariser according to any one of the preceding Claims, wherein
- a glass body with an inlet and an outlet for gas and with a further opening is provided,
- a plane window is inserted in the further opening, the circumference of which window corresponds to the circumference of the further opening and the thickness of which is less than the width of the inner surface of the glass body which forms the edge of the further opening and defines this, and
- the edge of the further opening is heated from outside at least twice such that the glass in the vicinity of the edge melts, so that a fused joint between the window and the edge is produced.

11. Method according to Claim 10, in which the edge or the edges of each window is/are ground prior to insertion and prior to fusion with the edge of the opening of the glass body, the edge in particular being ground cylindrically, and then cleaned with an acid, in particular with hydrofluoric acid.

12. Use of a test cell for a noble gas polariser according to any one of the device Claims 1-9 at pressures of at least 1 MPa (10 bar) inside the test cell.

## Revendications

1. Cellule à échantillons pour un polariseur de gaz rares avec un corps en verre (1) qui comporte une entrée (4) et une sortie (5) pour gaz,
**caractérisée par** les caractéristiques suivantes :
- le corps en verre présente au moins une autre ouverture,
- dans l'autre ouverture est introduite une fenêtre (2) plane en verre,
- la forme et la taille de la fenêtre (2) correspondent à la forme et à la taille de l'autre ouverture,
- l'autre ouverture est limitée par une surface intérieure, formant le bord de l'ouverture, du corps en verre,
- dans son étendue, la surface intérieure est plus large que la fenêtre n'est épaisse,
- le bord de la fenêtre est fondu avec le bord de l'ouverture.

2. Cellule à échantillons selon la revendication 1, **caractérisée en ce que** le corps en verre présente la forme d'un cylindre (1), la fenêtre plane (2) étant formée par une vitre qui est introduite dans le corps en verre à une extrémité du cylindre.

3. Cellule à échantillons selon l'une quelconque des revendications 1 ou 2, **caractérisée en ce que** la cellule à échantillons comporte deux fenêtres planes (2, 3) qui sont disposées parallèlement l'une à l'autre.

4. Cellule à échantillons selon l'une quelconque des revendications 1 à 3, **caractérisée par** deux rayons (8) faisant saillie d'au moins 1 millimètre des deux côtés de la ou des fenêtres, qui sont disposés directement au voisinage du pourtour de la fenêtre et qui forment une liaison résistant à la pression avec le bord de l'ouverture.

5. Cellule à échantillons selon l'une quelconque des revendications 1 à 4, **caractérisée par** du verre borosilicate (1), et du verre borofloat duquel sont constituées les fenêtres (2, 3).

6. Cellule à échantillons selon l'une quelconque des revendications 1 à 5, **caractérisée en ce que** le verre (1, 2, 3) présente une épaisseur d'au moins 5 millimètres.

7. Cellule à échantillons selon l'une quelconque des revendications 1 à 6, **caractérisée en ce que** le diamètre extérieur du corps en verre (1) est compris entre 20 et 100 millimètres, en particulier entre 35 et 40 millimètres.

8. Cellule à échantillons selon l'une quelconque des revendications 1 à 7, **caractérisée en ce que** la cellule à échantillons fait partie d'un polariseur pour la polarisation d'un gaz rare.

9. Cellule à échantillons selon l'une quelconque des revendications 1 à 8, **caractérisée en ce qu'**à l'entrée ou à la sortie du gaz sont prévues des soupapes (6, 7) réalisées en verre qui comprennent des bagues d'étanchéité en éthylène-propylène.

10. Procédé de fabrication d'une cellule à échantillons pour un polariseur de gaz rares selon l'une quelconque des revendications 1 à 9, dans lequel
- il est prévu un corps en verre avec une entrée et une sortie pour le gaz ainsi qu'avec une autre ouverture,
- dans l'autre ouverture est introduite une fenêtre plane dont le pourtour correspond au pourtour de l'autre ouverture et dont l'épaisseur est inférieure à la largeur de la surface intérieure du corps en verre qui forme le bord de l'autre ouverture et limite celle-ci, et
- le bord de l'autre ouverture est chauffé de l'extérieur au moins deux fois de façon que le verre fonde à proximité du bord, de manière qu'il en résulte une liaison par fusion entre la fenêtre et le bord.

11. Procédé selon la revendication 10, dans lequel le ou les bords de chaque fenêtre sont meulés avant introduction ainsi qu'avant la fusion avec le bord de l'ouverture du corps en verre, en particulier le bord est meulé arrondi puis est nettoyé avec un acide, en particulier de l'acide fluorhydrique.

12. Utilisation d'une cellule à échantillons pour un polariseur de gaz rares selon l'une quelconque des revendications 1 à 9 sous une pression d'au moins 1 MPa (10 bars) à l'intérieur de la cellule à échantillons.
